# EUROPÄISCHE PATENTSCHRIFT

(11) **EP 0 717 887 B1**
(45) Veröffentlichungstag und Bekanntmachung des Hinweises auf die Patenterteilung: **14.05.1997**
(21) Anmeldenummer: 93918962.7
(22) Anmeldetag: 08.09.1993
(51) Int. Cl.: H02H 9/02, H03K 17/687

(54) **WECHSELSTROMSTELLER**
A.C. CONTROLLER
REGULATEUR DE COURANT ALTERNATIF

(43) Veröffentlichungstag der Anmeldung: 26.06.1996
(73) Patentinhaber: SIEMENS AKTIENGESELLSCHAFT, 80333 München (DE)
(72) Erfinder: MAIER, Reinhard, D-91074 Herzogenaurach (DE); ZIERHUT, Hermann, D-93073 Neutraubling (DE); MITLEHNER, Heinz, D-91080 Uttenreuth (DE)
(86) Internationale Anmeldenummer: DE9300825
(87) Internationale Veröffentlichungsnummer: WO9507571

(56) Entgegenhaltungen:
- WO-A-93/11608
- GB-A- 2 065 404

## Beschreibung

Die Erfindung bezieht sich auf einen Wechselstromsteller, der zumindest mit zwei antiseriellen Halbleiterbereichen arbeitet. Die Halbleiterbereiche, die jeweils mit Elektronenspender (Source), Elektronensammler (Drain) und den Elektronenfluß steuernder Elektrode (Gate) versehen sind, weisen Kennlinien wie FETs auf. Nach derzeitigem Erkenntnisstand weisen sie im Inversbetrieb technologiegebunden auch eine innere Bodydiode auf.

Mit zwei antiseriellen FETs arbeitet ein bekannter Leistungsschalter (WO 93/11608), bei dem elektrisch parallel zu einem Halbleiterelement mit zwei antiseriellen FETs das Auslöseglied eines als Relais wirkenden Bauelements angeordnet ist, das mittels Unterbrecherkontakten einen zu schützenden Leitungszug unterbrechen kann. Das Halbleiterelement ist dort so eingestellt, daß sein Innenwiderstand bei einer bestimmten Steuerspannung an einer Steuerelektrode und einer Arbeitsspannung an in Durchgangsrichtung in einem Leitungszug liegenden Arbeitselektroden einen niedrigen Wert aufweist und daß der Innenwiderstand mit steigender Spannung an den Arbeitselektroden sprunghaft ansteigt. Bei Anstieg des Innenwiderstands wird an das parallel angeordnete Auslöseglied Spannung gelegt, die zum Auslösen führt.

Elektrische Anlagen müssen an ein Netz geschaltet, bzw. vom Netz getrennt werden. Bei mechanischen Schaltern liegen optimierte Lösungen vor, die den technischen Anforderungen, beispielsweise bei Antrieben, Motorschutzschaltern hinsichtlich Überlast- und Kurzschlußschutz in der Praxis genügen. Bei Schutzschaltgeraten allgemein, zu denen Leistungsschalter, Motorschutzschalter oder Leitungsschutzschalter gehören, ist es wünschenswert, auftretende Überlastströme, insbesondere Kurzschlußströme, rasch zu erfassen und sie auf kleine Werte zu begrenzen und schließlich abzuschalten. Nachteile der mechanischen Schutzschaltgeräte sind der Verschleiß der Kontakte, häufige Wartung und verhältnismäßig langsame Schaltzeit im Kurzschlußfall sowie eine verhältnismäßig geringe zeitliche Genauigkeit des Schaltzeitpunktes.

Halbleiterschalter können dagegen verschleißfrei arbeiten, schnell schalten; sie haben geringe Schaltverluste und sie lassen sich variabel steuern. Nachteilig bei Halbleiterschaltern sind dagegen: hohe Kosten, hoher Platzbedarf und verhältnismäßig hohe Durchlaßverluste.

Allgemein gesehen ist es häufig wünschenswert, Wechselströme rasch auf bestimmte Werte zu begrenzen, sodaß Überströme verträglich werden oder damit Zeit zum Abschalten verbleibt. Halbleiterelemente können auch so betrieben werden, daß sie einen Strom bis zum Abschalten herunterführen.

Der Erfindung liegt die Aufgabe zugrunde, einen vorteilhaften Wechselstromsteller in Halbleitertechnik zu entwickeln. Der Erfindung liegt dabei die Erkenntnis zugrunde, daß die zuvor geschilderten Geräte und Elemente als Wechselstromsteller im weitesten Sinne ausgeführt werden können.

Die Lösung der geschilderten Aufgabe erfolgt nach der Erfindung durch einen Wechselstromsteller nach Patentanspruch 1. Hierbei sind bei antiseriellen Halbleiterbereichen jeweils am Halbleiterbereich in Durchlaßrichtung die Gate-Source-Spannung so groß eingestellt, daß sich eine gewünschte Begrenzung des Drain-Source-Stromes einstellt. Am Halbleiterbereich im Inversbetrieb ist jeweils die Gate-Source-Spannung so eingestellt, daß die Bodydiode noch stromlos ist. Der zweite Halbleiterbereich weist also bei diesem Strom einen solchen Spannungsabfall auf, daß seine Bodydiode noch stromlos ist. Der Erfindung liegt hierbei die Erkenntnis zugrunde, daß sich die Durchlaßverluste bei einschlägigen Halbleiterelementen aus den Verlusten im Schaltelement und aus den Verlusten häufig in Serie geschalteter, zusätzlicher Freilaufdioden zusammensetzt. Beim Wechselstromsteller erübrigen sich besondere Freilaufdioden, da bipolare Leitfähigkeitsmechanismen und damit zusammenhängende Speicherladungen nicht auftreten. Man benötigt daher weder gesonderte Freilaufdioden, noch kommt die halbleitertechnisch bedingte Bodydiode zur Wirkung. Der Wechselstromsteller arbeitet daher mit besonders niedrigen statischen und dynamischen Verlusten. Unter statischen Verlusten werden die Verluste im Stromdurchgang und unter dynamischen Verlusten Umschaltverluste erfaßt.

Wenn die Halbleiterbereiche aus Siliciumcarbid, SiC, gebildet sind, ergeben sich im Kennlinienfeld besonders große und günstige Arbeitsbereiche. Die Halbleiterbereiche können in einem Mikrochip ausgebildet sein oder auch als diskrete FETs ausgeführt werden.

Die Erfindung soll nun anhand von in der Zeichnung grob schematisch wiedergegebenen Ausführungsbeispielen näher erläutert werden.

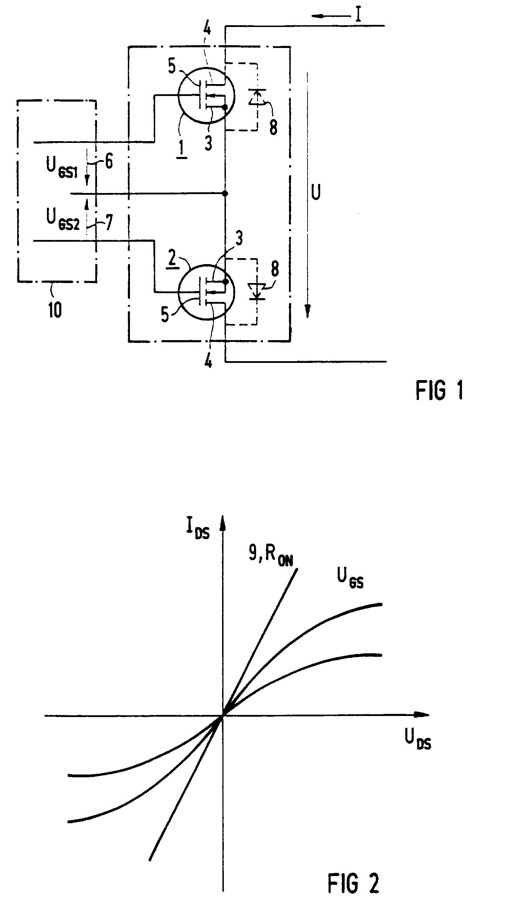

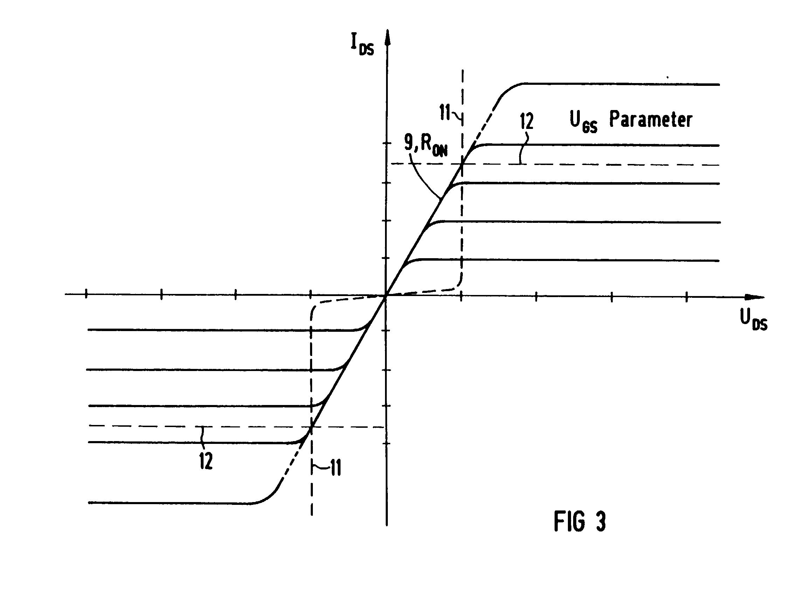

In Figur 1 ist ein Wechselstromsteller veranschaulicht. In Figur 2 ist für einen Halbleiterbereich der Drain-Source-Strom, I_{DS}, über der Drain-Source-Spannung, U_{DS}, für Parameter mit der Gate-Source-Spannung, U_{GS,}in der Nähe des Ursprungs für zwei antiserielle Bereiche veranschaulicht. In Figur 3 ist in einem anderen Maßstab unter Einbeziehung höherer Drain-Source-Spannungen ein Kennlinienfeld für I_{DS} auf der Ordinate und auf U_{DS} auf der Abszisse für antiseriell geschaltete Halbleiterbereiche dargestellt.

Der Wechselstromsteller nach Figur 1 arbeitet mit zwei antiseriellen Halbleiterbereichen 1 und 2, die im Ausführungsbeispiel als diskrete FETs dargestellt sind. Jeder Halbleiterbereich weist eine Source 3, ein Drain 4 und ein Gate 5 auf. In Durchlaßrichtung, beispielsweise am Halbleiterbereich 1, ist die Gate-Source-Spannung 6,U_{GS 1}, so groß eingestellt, daß sich eine gewünschte Begrenzung des Drain-Source-Stroms einstellt. Die Gate-Source-Spannung ist hierbei Parameter zu Strombegrenzungslinien, wie sie in Figur 3 dargestellt sind. Am Halbleiterbereich im Inversbetrieb, im Ausführungsbeispiel nach Figur 1 sei es der Halbleiterbereich 2, ist die Gate-Source-Spannung 7, U_{GS 2} nur so groß eingestellt, daß die Bodydiode 8 stromlos ist. Bei einem FET aus Siliciumcarbid beträgt die Schwellspannung beispielsweise etwa 2,8 V. Bei Silicium sind Schwellspannungen von etwa 0,7 V gängig. Die Gate-Source-Spannung am Halbleiterbereich 2 ist dann so einzustellen, daß der Spannungsfall am Arbeitspfad niedriger ist als die Schwellspannung der Bodydiode ist.

Die Halbleiterbereiche 1 und 2 können aus Siliciumcarbid gebildet sein und insbesondere in einem Mikrochip ausgeführt werden. Die Halbleiterbereiche können auch als diskrete FETs, insbesondere als MOSFETs, ausgeführt sein.

Beim Wechselstromsteller nach Figur 1 genügt eine Gate-Ansteuerung für beide Halbleiterbereiche 1,2 in beiden Stromrichtungen, allerdings auf verschieden hohem Potential. Der Wechselstromsteller stellt einen Strom I bei einer anliegenden Spannung U in Abhängigkeit von der Gate-Source-Spannung 6,7 auf einen gewünschten Wert im Arbeitskennfeld ein.

Bei einem Halbleiterbereich mit Kennlinien, wie sie FETs aufweisen, ergeben sich bei antiseriell geschalteten Halbleiterbereichen bei kleinen Drain-Source-Spannungen Kennlinien nach Figur 2. Mit steigender Gate-Source-Spannung, U_{GS,} als Parameter lehnen sich die Kennlinien beginnend im Ursprung immer stärker an die gerade 9, R_{ON} an. In anderer Betrachtungsweise wird bei hohen Gate-Source-Spannungen eine steile Kennlinie für den ON-Widerstand, also ein sehr niedriger ON-Widerstand, erreicht. Diese als Widerstand zu interpretierende Kennlinie zeigt ein lineares, also ohmsches Verhalten. Bei antiserieller Beschaltung verlaufen die Kennlinien und R_{ON} im ersten und dritten Quadranten. Beispielsweise ist bei Siliciumcarbid der durch R_{ON} verursachte Spannungsfall in Durchlaßrichtung deutlich niedriger als die Schwellspannung der Bodydiode.

In Figur 3 ist ein Kennlinienfeld nach Art von Figur 2 bis zu höheren Drain-Source-Spannungen und Parametern mit höherer Gate-Source-Spannung bei anderem Maßstab dargestellt. Für gegebene Gate-Source-Spannungen ergeben sich den Drain-Source-Strom begrenzende Kennlinien in etwa parallel zur Abszisse. Der Einfachheit halber sei angenommen, daß FETs des Anreicherungstyps (Enhancement) für die Halbleiterbereiche eingesetzt werden, die selbstsperrend sind und einen n-Kanal aufweisen. Die Darstellungsweise in Figur 1 korrespondiert hierzu. Die Bodydioden 8 ergeben eine Überlagerung mit einer Kennlinie 11 im ersten und dritten Quadranten. Ein Betrieb auf der Kennlinie 11, die veranschaulicht, daß die Bodydiode parallel zum Arbeitspfad des Halbleiterbereichs in Sperrrichtung wirksam wird, läßt sich vermeiden, indem am Halbleiterbereich im Inversbetrieb die Gate-Source-Spannung nur so groß eingestellt wird, daß die Bodydiode noch stromlos ist, daß man also mit anderen Worten in einem Arbeitsbereich zwischen Abszisse und Grenzlinie 12 durch den Schnittpunkt des RON-Widerstands 9 mit der Kennlinie 11 für die Bodydiode bleibt. Dadurch vermeidet man bei jeder Betriebsart bipolare Leitfähigkeitsmechanismen, so daß Speicherladungen nicht auftreten, wodurch die statischen und dynamischen Verluste des Wechselstromstellers niedrig gehalten werden.

Durch eine geeignete Gate-Source-Spannung als Parameter im Kennlinienfeld nach Figur 3 kann ein gewünschter Drain-Source-Strom bei Überspannungen eingestellt werden. Im Normalbetrieb des Wechselstromstellers treten entsprechend der Kennlinie 9 für den R_{ON}-Widerstand nur niedrige Verluste auf, die umso niedriger sind, je steiler die Kennlinie 9 verläuft. Bei Siliciumcarbid und insbesondere bei einer Struktur nach Art eines MOSFETs ist es möglich, beispielsweise etwa zwischen 300 und 5000 V für die Spannung U nach Figur 1 strombegrenzend zu wirken. Die jeweilige Gate-Source-Spannung kann durch eine Ansteuerschaltung 10 nach Figur 1 in an sich bekannter Weise erzeugt werden. Wenn jeweils am Halbleiterbereich im Inversbereich die Gate-Source-Spannung nur so groß eingestellt wird, daß die Bodydiode des betreffenden Halbleiterbereichs noch stromlos ist, benötigt man keine gesonderten Freilaufdioden, um die dynamischen Verluste zu senken, da sie im wesentlichen gar nicht auftreten.

Der hier beschriebene Wechselstromsteller kann die verschiedenartigsten Anwendungen finden. So kann er beispielsweise als besonderer Limiter in Reihe zu handelsüblichen Schutzschaltern eingesetzt werden, wobei der Strom im Limiter auf einen bestimmten Wert bei Überspannungen begrenzt wird. Bei Nennbetrieb weist er andererseits einen so niedrigen Widerstand auf, daß die statischen Verluste niedrig bleiben. Der Wechselstromsteller kann aber auch als Schalter ausgeführt werden, der bei entsprechender Gate-Source-Spannung bei Überspannungen den Strom zunächst auf ein vorbestimmtes Maß begrenzt und bei entsprechend laufend erniedrigten Gate-Source-Spannungen den Strom abgesenkt wird. Der Wechsestromsteller kann auch allgemein dazu herangezogen werden, in einem Arbeitsbereich unabhängig von der Spannung U einen bestimmten Strom I einzustellen.

## Patentansprüche

1. Wechselstromsteller, der zumindest mit zwei antiseriellen Halbleiterbereichen (1, 2) arbeitet, jeweils mit Elektronenspender (3), Elektronensammler (4) und den Elektronenfluß steuernder Elektrode (5) und Kennlinien, wie sie FETs aufweisen, also technologiegebunden auch mit innerer Bodydiode, wobei der erste Halbleiterbereich (1; 2), der in Durchlaßrichtung betrieben wird, eine Spannung zwischen den Anschlüssen Elektronenspender (3) und steuernder Elektrode (4), also z. B aine Gate-Source-Spannung (6; 7), aufweist, die so gewählt ist, daß sie die Begrenzung des Wechselstromstellerstromes auf einen vorgegebenen Wert festlegt, und wobei die genannte Spannung, also z.B die Gate-Source-Spannung, des zweiten Halbleiterbereichs (2; 1), der im Inversbetrieb arbeitet, und der vorgegebene Wert des Wechselstromstellerstromes des ersten Halbleiterbereichs (1; 2) so gewählt sind, daß der zweite Halbleiterbereich (2; 1) bei diesem Strom einen solchen Spannungsabfall aufweist, daß seine Bodydiode (8) noch stromlos ist.

2. Wechselstromsteller nach Anspruch 1,
**dadurch gekennzeichnet**,
daß die Halbleiterbereiche (1,2) aus Siliciumcarbid (SiC) gebildet sind.

3. Wechselstromsteller nach Anspurch 2,
**dadurch gekennzeichnet**,
daß die Halbleiterbereiche (1,2) in einem Mikrochip ausgebildet sind.

4. Wechselstromsteller nach Anspruch 2,
**dadurch gekennzeichnet**,
daß die Halbleiterbereiche (1,2) als diskrete FETs ausgeführt sind.

## Claims

1. AC power controller, which operates at least with two reverse-connected series semiconductor regions (1, 2), each having an electron donor (3), an electron sink (4) and an electrode (5) which controls the flow of electrons, and characteristic curves such as those exhibited by FETs, in other words also having an internal body diode, dictated by the technology, the first semiconductor region (1; 2), which is operated in the forward direction, having a voltage between the connections of electron donor (3) and controlling electrode (4), that is to say, for example, a gate-source voltage (6; 7), which is selected in such a way that it defines the limiting of the AC power controller current to a predetermined value, and the abovementioned voltage, that is to say, for example, the gate-source voltage, of the second semiconductor region (2; 1), which operates in the inverse mode, and the predetermined value of the AC power controller current of the first semiconductor region (1; 2) being selected in such a way that the second semiconductor region (2; 1) has at this current a voltage drop such that its body diode (8) is still de-energized.

2. AC power controller according to Claim 1, characterized in that the semiconductor regions (1, 2) are formed from silicon carbide (SiC).

3. AC power controller according to Claim 2, characterized in that the semiconductor regions (1, 2) are formed in a microchip.

4. AC power controller according to Claim 2, characterized in that the semiconductor regions (1, 2) are designed as discrete FETs.

## Revendications

1. Régulateur de courant alternatif, qui fonctionne avec au moins deux zones (1, 2) de semi-conducteur antisérielles, comportant chacune des donneurs (3) d'électrons, des collecteurs (4) d'électrons et une électrode (5) commandant le courant d'électrons et des caractéristiques, comme celles qu'ont les transistors à effet de champ, donc dépendant de la technologie et ayant également une diode de volume interne, la première zone (1 ; 2) de semi-conducteur, qui fonctionne dans le sens direct, ayant une tension entre les bornes de donneurs d'électrons (3) et l'électrode (4) de commande donc par exemple une tension (6 ; 7) grille-source, qui est choisie de sorte qu'elle fixe la limitation du courant du régulateur de courant alternatif à une valeur prescrite, et ladite tension, donc par exemple la tension grille-source, de la seconde zone (2; 1) de semi-conducteur qui fonctionne de manière inverse et la valeur prescrite du courant du régulateur de courant alternatif de la première zone (1 ; 2) de semi-conducteur sont choisies de telle sorte que la seconde zone (2 ; 1) de semi-conducteur ait, pour ce courant, une chute de tension telle que sa diode (8) de volume soit encore sans courant.

2. Régulateur de courant alternatif suivant la revendication 1,
caractérisé en ce que
les zones (1, 2) de semi-conducteur sont en carbure de silicium (SiC).

3. Régulateur de courant alternatif suivant la revendication 2,
caractérisé en ce que
les zones (1, 2) de semi-conducteur sont formées dans une micropuce.

4. Régulateur de courant alternatif suivant la revendication 2,
caractérisé en ce que
les zones (1, 2) de semi-conducteur sont réalisées en tant que transistors à effet de champ discrets.
